# EUROPÄISCHE PATENTSCHRIFT

(11) **EP 0 954 622 B1**
(45) Veröffentlichungstag und Bekanntmachung des Hinweises auf die Patenterteilung: **11.07.2001**
(21) Anmeldenummer: 97951845.3
(22) Anmeldetag: 10.12.1997
(51) Int. Cl.: C23C 16/30, C23C 30/00

(54) **VERBUNDKÖRPER UND VERFAHREN ZU SEINER HERSTELLUNG**
COMPOSITE BODY AND PRODUCTION PROCESS
CORPS COMPOSITE ET PROCEDE DE FABRICATION

(30) Priorität: 21.01.1997 DE 19701863; 07.03.1997 DE 19709300; 28.08.1997 DE 19737470
(43) Veröffentlichungstag der Anmeldung: 10.11.1999
(73) Patentinhaber: Widia GmbH, 45145 Essen (DE)
(72) Erfinder: KÖNIG, Udo, D-45149 Essen (DE); WESTPHAL, Hartmut, D-36466 Dermbach (DE); SOTTKE, Volkmar, D-45472 Mülheim (DE)
(74) Vertreter: Vomberg, Friedhelm, Dipl.-Phys.
(86) Internationale Anmeldenummer: DE9702889
(87) Internationale Veröffentlichungsnummer: WO9831846

(56) Entgegenhaltungen:
- DD-A- 288 629
- DE-A- 2 505 009
- US-A- 4 714 660
- PATENT ABSTRACTS OF JAPAN vol. 002, no. 152 (C-031), 20.Dezember 1978 -& JP 53 116207 A (MITSUBISHI METAL CORP), 11.Oktober 1978, -& CHEMICAL ABSTRACTS, vol. 90, no. 10, 5.März 1979 Columbus, Ohio, US; abstract no. 75571, KIKUCHI, NORIBUMI ET AL.: "Coated superhard alloy product" XP002061948
- CHEMICAL ABSTRACTS, vol. 118, no. 24, 14.Juni 1993 Columbus, Ohio, US; abstract no. 239403, SATO, YUJI ET AL: "Multilayer coated silicon nitride ceramics for cutting tools" XP002061943 -& JP 04 357 174 A (TOSHIBA TUNGALOY CO LTD, JAPAN)

## Beschreibung

Die Erfindung betrifft einen Verbundkörper, der aus einem Substratkörper mit einer ein- oder mehrlagigen Beschichtung besteht.

Die Erfindung betrifft ferner ein Verfahren zur Herstellung einer Schicht auf einen Substratkörper aus einem Hartmetall, Cermet oder einer Keramik.

Die ersten, nach dem Stand der Technik bekanntgewordenen Beschichtungen bestanden aus Titancarbid mit einer Dicke bis zu 8 µm, womit eine verbesserte Verschleißschutzwirkung gegen den Freiflächenverschleiß erzielt werden konnte. Weiterhin gehören Doppel- oder Mehrfachbeschichtungen aus Titancarbid und Titannitrid, insbesondere mit Titannitrid als Außenlage zum Stand der Technik, womit eine verminderte Kolkung bei zum Zerspanen eingesetzten Schneideinsätzen erreicht werden konnte. Zur weiteren Verbesserung solcher Schneideinsätze sind auch Mehrlagenbeschichtungen mit der Schichtfolge TiC, Ti(C,N)-TiN vorgeschlagen worden. Nachdem man erkannt hatte, daß die naturbedingte Sprödigkeit von Keramiken, wie Al₂O₃ minimiert werden kann, wenn Al₂O₃ in dünnlagiger Form aufgetragen wird, sind auch aus TiC, Ti(C,N) und einer Außenlage aus Al₂O₃ bestehende Mehrfachbeschichtungen verwendet worden. Obwohl in der Patentliteratur wie beispielsweise im Rahmen der ein spezielles Beschichtungsverfahren betreffenden EP 0 229 282 B1 generell von Carbiden, Nitriden und/oder Carbonitriden der Elemente Titan, Zirkonium, Hafnium, Vanadium, Niob und/oder Tantal gesprochen wird, beschränkten sich die jeweils beschriebenen Ausführungsbeispiele auf Titanverbindungen als Beschichtungsmaterial, zum Teil in Kombination mit Aluminiumoxid. Entsprechendes gilt hinsichtlich der ZrO₂ in Verbindung oder als Ersatz für oxidhaltige Beschichtungen. Erst in der DE 36 20 901 A1 oder der inhaltlich gleichlautenden EP 0 250 865 A1 ist ein Schneidwerkzeug beschrieben, dessen Schneide mit Titancarbid, Titancarbonitrid und/oder Titannitrid beschichtet ist und dessen äußere Deckschicht aus einer dünnen Zirkonnitridschicht bestehen soll. Das Zirkonnitrid, das schlechtere Verschleißeigenschaften als die vorgenannten Titan-Verbindungen hat, soll eine Oxidation der unter dieser Schicht liegenden Basisbeschichtungen durch den Luftsauerstoff verhindern, womit die guten Verschleißeigenschaften der Titancarbid-, Titancarbonitrid- und/oder Titannitridschichten voll erhalten bleiben.

Darüber hinaus wird noch in der US-A-3 854 991 (oder CH-A-585 273) ein beschichtetes Sinterhartmetallprodukt beschrieben, bei dem der Überzug aus HfCN und/oder ZrCN besteht und eine Röntgenbeugungs-Gitterkonstante haben soll, welche im Falle von HfCN und einer Mischung aus HfCN und ZrCN zwischen 4,570 und 4,630 Angström liegt und im Fall von ZrCN zwischen 4,6 und 4,62 Angström. Im Falle von ZrCN ist das C/N-Verhältnis deutlich kleiner als 1. Zur Herstellung dieses Hafnium- oder Zirkoniumcarbonitrids wird ein Hafnium- und/oder Zirkoniumhalogenid zusammen mit Wasserstoff, Stickstoff und einem Kohlenwasserstoff bei einer Temperatur von 1000 bis 1300°C über das Substrat geleitet.

Die US-A-4 714 660 beschreibt einen Schneideinsatz aus einem CVD-beschichteten Substratkörper, bei dem die erste CVD-Schicht aus mindestens zwei simultan zusammen abgeschiedenen Phasen besteht, von denen die erste aus der Gruppe der Carbide, Carbonitride, Nitride, Oxicarbide, Oxicarbonitride, Silizide oder Boride des Titans, Zirkoniums, Hafniums, Vanadiums, Niobs und Tantals, eines Carbids, Silizids oder Borids des Chroms Molybdäns und Wolframs und eines Carbids des Silikons oder Bors besteht und die zweite der genannten Phasen aus der Gruppe der Oxide oder Oxinitride des Aluminiums, Titans, Zirkoniums, Hafniums, Magnesiums, Siliziums und Calciums oder aus stabilisiertem Zirkoniumoxid ausgewählt ist. Von den genannten abgeschiedenen Phasen besteht wenigstens eine Phase aus Fasern, Stengel oder säulenförmigen Teilchen mit einer längsaxialen Orientierung in einer Richtung, die senkrecht zur Substrat/Beschichtungsoberfläche des Verbundwerkstoffes steht.

Es ist Aufgabe der vorliegenden Erfindung, einen Verbundkörper der eingangs genannten Art zu schaffen, der eine hohe Mikrohärte aufweist und der gute Verschleißeigenschaften besitzt, insbesondere bei Zerspanungsoperationen, wie dem Drehen oder Fräsen, oder als abrasiv belastetes Verschleißteil.

Diese Aufgabe wird durch den Verbundkörper nach Anspruch 1 gelöst, der erfindungsgemäß dadurch gekennzeichnet ist, daß mindestens eine Schicht zwei oder drei Phasen aufweist, die kubischem ZrCN und monoklinem und/oder tetragonalem ZrO₂ bestehen.

Bei der CVD-Abscheidung von TiCN führt in der Gasatmosphäre enthaltener Sauerstoff dazu, daß dieser in das (einphasige) Gefüge eingelagert wird, wobei Ti (C, O, N)-Abscheidungen entstehen. überraschenderweise führt jedoch ein Sauerstoffgehalt in der Gasphase bei Einhaltung bestimmter Randbedingungen zur Abscheidung zweier nebeneinanderliegender Phasen in der Beschichtung, nämlich ZrCN und ZrO₂. Dies war bei der chemischen Ähnlichkeit des Zirkons und des Titans, die beide derselben Gruppe des Periodensystemes angehören, ebensowenig zu erwarten wie eine gute Haftfestigkeit der betreffenden Schicht auf dem Substratkörper oder auf einer anderen Schicht bzw. als Zwischenlage. Die neue Beschichtung hat auch bei Verbundkörpern, die als Schneideinsätze ausgebildet waren, zu erheblichen Standzeitverbesserungen beim Fräsen von Stahl geführt. Die Standzeiten konnten um 30 % verlängert werden. Weiterhin eignet sich diese Beschichtung in besonderer Weise für die Leistungsverbesserung von Umformwerkzeugen, die einem Reibverschleiß ausgesetzt sind.

Weitere Ausgestaltungen dieses Verbundkörpers sind in den Unteransprüchen beschrieben.

So wird die Dicke der erfindungsgemäßen Schicht auf 2 bis 10 µm, vorzugsweise mindestens 3 µm begrenzt. Wegen der nach dem Stand der Technik bekannten unterschiedlichen Eigenschaften des ZrCN einerseits und des ZrO₂ andererseits, die jeweils vorteilhaft ausgenutzt werden können, besteht ein weiterer Grundgedanke der Erfindung darin, in der Schicht einen Gradientenverlauf hinsichtlich der relativen ZrO₂/ZrCN-Anteile einzustellen. Je nach gewünschter Randzone kann beispielsweise der ZrO₂-Gehalt in der Schicht nach außen hin abnehmen. So ist beispielsweise für die Gußbearbeitung ein höherer ZrCN-Gehalt zu empfehlen, weshalb bei Verwendung der ZrCN/ZrO₂-Schicht als Außenlage oder einziger Schicht für Schneideinsätze, die zur Gußbearbeitung eingesetzt werden sollen, der ZrO₂-Relativgehalt nach außen hin bevorzugt auf 0 abnimmt. Umgekehrt ist die Haftfestigkeit von ZrO₂ auf Substratkörpern sowie auf anderen Schichten zum Teil besser als die des ZrCN, weshalb der ZrO₂-Anteil nach innen hin vorzugsweise zum Grenzbereich zum Substratkörper wächst, ggf. bis zu 100 %. Die betreffende Gradienteneinstellung kann bei der CVD-Beschichtung durch Einstellung des CO₂-Gehaltes in Abhängigkeit von der Zeit vorgenommen werden.

Abgesehen von den bereits beschriebenen Randzonen wird bevorzugt, insbesondere bei 2-Phasen-Beschichtungen mit einer homogenen Verteilung der relative Massenanteil des ZrO₂ zwischen 5 und 75 Massen-%, weiterhin vorzugsweise zwischen 5 und 60 % und schließlich vorzugsweise zwischen 20 und 40 % gewählt. Die betreffenden ZrO₂-Anteile in der Schicht können im Hinblick auf den Einsatzzweck des Verbundkörpers gewählt und abgestimmt werden. Ferner kann das Verhältnis von monoklinem zu tetragonalem ZrO₂ über die Beschichtungstemperatur variiert werden. Vorzugsweise liegt dieses Verhältnis im Bereich (3 bis 4):(7 bis 6). So ergibt sich bei einer Beschichtungstemperatur von etwa 950°C ein 2/3 Anteil an tetragonalem ZrO₂ und 1/3 monoklinem ZrO₂ neben der ersten Zr(C,N)-Phase. Bei höheren Temperaturen wächst der tetragonale ZrO₂-Anteil, der bei ca. 1100°C Beschichtungs - temperatur 100 % beträgt. Die ZrCN-Phase liegt in kubischer Form vor. Als Substratkörper, auf den eine oder mehrere Lagen aufgetragen werden sollen, wovon eine die erfindungsgemäße Schicht ist, kommen Hartmetalle, Cermets oder eine Keramik infrage. Die Beschichtung kann mehrlagig sein und außer der Schicht aus ZrCN/ZrO₂, mindestens eine Schicht aus Carbiden, Nitriden und/oder Carbonitriden der Elemente der IVa- bis VIa-Gruppe des Periodensystemes aufweisen, ggf. kann auch eine Schicht aus Al₂O₃ und/oder ZrO₂ bestehen, wobei Dioxidschichten sowohl als äußerste Schicht als auch unterhalb der ZrCN/ZrO₂-Schicht, die äußere ist, liegen können. Schließlich kann auch eine diamantähnliche Schicht als Außenlage verwendet werden. Nach einer bevorzugten Anwendung besteht die Außenlage aus einer ZrCN/ZrO₂-Schicht, worunter eine Al₂O₃-Lage angeordnet ist. Gute Verschleißeigenschaften beim Zerspanen konnten auch mit folgender Schichtfolge (aufgeführt von innen nach außen) erzielt werden: TiN: 0,5 bis 2 µm, vorzugsweise bis 1 µm; TiCN: 2 bis 5 µm; ZrCN/ZrO₂: 2 bis 10 µm.

Bevorzugt wird die erfindungsgemäße Beschichtung aus ZrCN und ZrO₂, ggf. in Kombination mit weiteren Lagen anderer Zusammensetzung mittels des im Anspruch 8 beschriebenen Verfahrens aufgetragen. Zur CVD-Abscheidung werden Zr-Halogenide, insbesondere ZrCl₄, in stöchiometrischem Überschuß, CO₂, H₂ und ein Stoff mit einer C-N-Gruppe als Kohlenstoff- und Stickstoffdonator bei einem Druck zwischen 5 kPa und 100 kPa und Temperaturen zwischen 800°C bis 950°C eingelassen. Der stöchiometrische Überschuß des Zirkon-Halogenids ist erforderlich, um die Abscheidung von Kohlenstoff (Ruß) zu unterbinden. Der Stoff, der als C-N-Donator dient, besitzt vorzugsweise eine Cyanid-Gruppe mit einer Dreifachbindung zwischen dem Kohlenstoff und dem Stickstoff, deren Abstand bei Raumtemperatur zwischen 0,114 und 0,118 nm beträgt. Solche Verbindungen sind Cyanwasserstoff, Cyanamid, Cyanogen, Cyanoacethylen oder Acetonitril. Alternativ oder zum Teil können auch solche gasförmigen Verbindungen verwendet werden, die CN-Molekülgruppen mit einer einfachen Bindung zwischen dem Kohlenstoff und dem Stickstoff aufweisen, wie beispielsweise Methylamin und Ethylendiamin. Grundsätzlich kann auch die in der DE 25 05 009 A1 beschriebenen Verbindungen zurückgegriffen werden. Alternativ hierzu ist es auch möglich, solche Stoffe in das Reaktionsgefäß einzuschleusen, die in der Lage sind, betreffende Cyangruppen bei der oben angegebenen Reaktionstemperatur zu bilden. Bevorzugt liegt die Beschichtungstemperatur, d.h. die Temperatur des zu beschichtenden Substratkörpers bzw. des bereits mit einer oder mehreren Lagen beschichteten Substratkörpers zwischen 900°C und 920°C. Im Verlauf der Beschichtung kann vorzugsweise der CO₂-Gehalt in der Gasatmosphäre abgesenkt werden, so daß der Phasenanteil des ZrO₂ in der ZrCN/ZrO₂-Schicht mit fortschreitender Zeit geringer wird, sich somit ein Gradient in der Schicht einstellt. Durch Absenkung des CO₂-Anteiles auf 0 kann in entsprechender Weise der ZrO₂-Anteil ebenfalls auf 0 gesenkt werden. Umgekehrt läßt sich durch Erhöhung des CO₂-Anteiles und entsprechender Absenkung des Anteiles des C-N-Donators der ZrO₂-Anteil steigern.

Weitere Eigenschaften und Ausgestaltungen der Erfindung werden anhand des nachfolgend beschriebenen Ausführungsbeispieles deutlich.

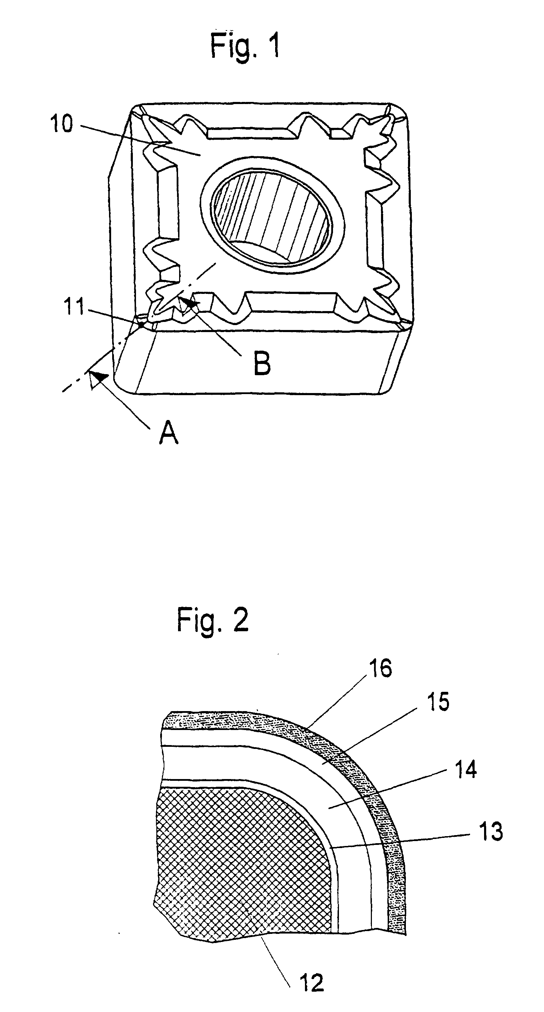

Fig. 1 zeigt ein Schneideinsatz 10 dessen Schneidecke 11 im Schnitt entlang der Linie A - B in Fig. 2 schematisch abgebildet ist.

Wie Fig. 2 zu entnehmen ist, ist auf dem Substratkörper 12, der aus einem WC-Hartmetall mit 6 % Co als Binder besteht, eine erste, 1 µm dicke Lage 13 aus TiN, eine zweite, 4 µm dicke Lage 14 aus TiCN, eine weitere, 2 µm dicke Lage 15 als Al₂O₃ und eine äußere, 3 µm dicke Deckschicht 16 ZrCN/ZrO₂ aufgetragen.

In einer weiteren Versuchsreihe wurden 1000 Wendeschneidplatten mit der Bezeichnung CNMG120412-49 aus einem Substratgrundkörper beschichtet. Die den Substratgrundkörper bildende Hartmetallegierung bestand aus 93,9 Massen-% WC und 6,1 Massen-% Co. Die Beschichtung wurde nach dem CVD-Verfahren in einer Apparatur vorgenommen, die Temperatureinstellungen bis 1100°C und Drücke zwischen 5 kPa und 100 kPa zuließ. In die Beschichtungsanlage können folgende Gase eingeleitet werden: Wasserstoff, Stickstoff, Kohlendioxid, Methan, Acetonitril, Titantetrachlorid, Zirkontetrachlorid und Aluminiumtrichlorid.

Die Hälfte der Substratkörper wurde bei 990°C mit einer Mehrlagenbeschichtung aus den nachfolgend aufgeführten Einzelschichten beschichtet:

| Einzelschicht | Dicke (µm) | Verwendete Gase |
|---|---|---|
| TiN | 1,5 | H₂, N₂, TiCl₄ |
| Ti(C,N) | 4,5 | H₂, N₂, CH₄, TiCl₄ |
| Al₂O₃ | 3,0 | H₂, CO₂, AlCl₃ |
| TiN | 1,0 | H₂, N₂, TiCl₄ |
| gesamte Dicke | 10,0 µm | |

Die vorgenannte Beschichtung ist nach dem Stand der Technik bekannt.

In einer weiteren Beschichtungsreihe sind die genannten Substratkörper bei 990°C mit einer mehrlagigen Beschichtung folgender Einzelschichten versehen worden:

| Einzelschicht | Dicke (µm) | Verwendete Gase |
|---|---|---|
| TiN | 1,5 | H₂, N₂, TiCl₄ |
| Ti(C,N) | 4,5 | H₂, N₂, CH₄, TiCl₄ |
| Zr(C,N)/ZrO₂ | 3,6 | H₂, CH₃CN, CO₂, ZrCl₄ |
| gesamte Dicke | 9,6 µm | |

In der ersten und der zweiten Beschichtungsreihe sind somit einheitlich als erste Schichten TiN und Ti(C,N) aufgetragen worden. Unterschiedlich sind nur die Außenlagen, die in einem Fall aus einer Al₂O₃- und einer äußeren TiN-Schicht bestanden und aus der erfindungsgemäßen Schicht aus ZrCN und ZrO₂. Die letztgenannte Beschichtung wurde analysiert, wobei mit Hilfe eines Lichtmikroskopes und eines Rasterelektronenmikroskopes beobachtet werden konnte, daß die unter Verwendung der Reaktionsgase H₂, CH₃CN, CO₂ und ZrCl₄ hergestellte Einzelschicht zwei verschiedene Phasen besitzt, die röntgendiffraktometrisch als kubisches Zirkoncarbonitrid und monoklines Zirkonoxid feststellbar waren. Dieses Ergebnis ist überraschend, weil normalerweise bei der CVD-Abscheidung aus Gasgemischen, die theoretisch zum Niederschlag von zwei oder mehreren Feststoffen geeignet sein müßten, erfahrungsgemäß nur ein Feststoff abgeschieden wird, nämlich die thermodynamisch stabilste Phase. Dies konnte auch in einem weiteren Versuch bestätigt werden, bei dem zur CVD-Abscheidung ein Gasgemisch aus H₂, CH₄, N₂, CO₂ und ZrCl₄ eingelassen wurde. Die abgeschiedene Schicht bestand im wesentlichen aus ZrO₂ und besaß eine geringere Härte als die erfindungsgemäße ZrCN/ZrO₂-Beschichtung. Dies zeigt, daß zur Abscheidung der erfindungsgemäßen Schicht ein Stoff mit einer C-N-Gruppe als Kohlenstoff- und Stickstoff-Donator anwesend sein muß.

Nach der vorliegenden Erfindung ist es ebenso möglich, die Gaszusammensetzung während der Beschichtung zu ändern, beispielsweise in dem das Verhältnis der relativen Gasanteile CH₃CN/CO₂ geändert wird. Hierdurch kann insbesondere im unteren Teil der letzten Schicht ein großer Anteil ZrCN und im oberen Teil eine Anreicherung von ZrO₂ erzielt werden.

Jeweils Gruppen der vorgenannten Wendeschneidplatten mit der Beschichtung TiN, Ti(C,N), Al₂O₃ und TiN als Repräsentanten von nach dem Stand der Technik bekannten Schneideinsätzen und mit einer erfindungsgemäßen Beschichtung aus TiN, Ti(C,N), Zr(C,N)/ZrO₂ sind zum Drehen einer Welle von 300 mm Durchschnitt aus einem zähen Stahlwerkstoff X5CrNi1810 (rostfreier Stahl) eingesetzt worden. Die jeweiligen Schneidplatten hatten Gesamtschichtdicken, die sich um nicht mehr als 0,4 µm voneinander unterschieden. Folgende Schnittbedingungen lagen vor:

| | |
|---|---|
| Schnittgeschwindigkeit | v_{c} = 160 m/min |
| Schhnittiefe | aₚ = 2 mm |
| Vorschub | f = 0,4 mm/Umdrehung. |

Mit den nach dem Stand der Technik bekannten beschichteten Wendeschneidplatten konnten Standzeiten von 12 Minuten im Mittel erreicht werden. Die erfindungsgemäßen Wendeschneidplatten erreichten Standzeiten von 18,5 Minuten. Dieses Ergebnis zeigt, daß die erfindungsgemäßen Schneideinsätze erheblich bessere Verschleißeigenschaften besitzen.

In einem weiteren Ausführungsbeispiel ist eine Stauchmatrize gefertigt worden, die eine erfindungsgemäße äußere Beschichtung aus ZrCN und ZrO₂ besitzt. Diese Beschichtung eignet sich wegen der Wirkung des ZrO₂ als Trockenschmierstoff und wegen seiner besonders geringen chemischen Affinität zu metallischen Werkstoffen für spanlose Formgebungsverfahren.

Bei der Herstellung von Ventilstößeln für Ottomotoren, die aus einer Co-Ni-Superlegierung bestehen, sind die Ventilstößel vor der Umformung auf ca. 600°C vorgewärmt und anschließend in eine Hartmetallmatrize aus WC mit 15 M-% Cobalt gegeben. Nach jeweils etwa 10000 Stauchvorgängen mußte die Matrize nachpoliert werden.

In einem zweiten Arbeitsgang ist die Hartmetallmatrize aus WC mit 15 M-% Cobalt mit 1,2 µm TiN und 5 µm ZrCN/ZrO₂ beschichtet worden, wobei der ZrO₂-Anteil zu 2/5 in monokliner und zu 3/5 in tetragonaler Form vorlag. 124 bearbeitete Stücke zeigten, daß die Matrize jeweils erst nach jeweils 50000 Bearbeitungsvorgängen nachpoliert werden mußte. Die erfindungsgemäße Beschichtung führt somit bei spanlos arbeitenden Werkzeugen zu einer deutlichen Standzeitverbesserung.

## Patentansprüche

1. Verbundkörper, bestehend aus einem Substratkörper mit einer ein- oder mehrlagigen Beschichtung,
**dadurch gekennzeichnet,**
daß mindestens eine Schicht zwei oder drei Phasen aufweist, bestehend aus kubischem ZrCN und monoklinem und/oder tetragonalem ZrO₂.

2. Verbundkörper nach Anspruch 1, dadurch gekennzeichnet, daß die ZrCN/ZrO₂-Schicht eine Dicke von mindestens 2 µm, vorzugsweise 3 µm, bis 10 µm aufweist.

3. Verbundkörper nach Anspruch 1 oder 2, dadurch gekennzeichnet, daß die ZrCN/ZrO₂-Schicht ein von dem Stand zur Grenzfläche abhängiges unterschiedliches Massenverhältnis ZrCN/ZrO₂ aufweist, wobei vorzugsweise der ZrO₂-Gehalt der ZrCN/ZrO₂-Schicht, die die einzige oder äußerste Schicht ist, nach außen abnimmt, vorzugsweise bis auf 0.

4. Verbundkörper nach Anspruch 3, dadurch gekennzeichnet, daß die ZrCN/ZrO₂-Schicht eine erste von mehreren Schichten oder eine Zwischenschicht ist und einen nach innen auf 100 % wachsenden ZrO₂-Anteil aufweist, vorzugsweise als Grenzbereich zum Substratkörper.

5. Verbundkörper nach einem der Ansprüche 1 bis 4, dadurch gekennzeichnet, daß der relative Massenanteil der ZrO₂-Phase zwischen 5 und 75 Massen-%, vorzugsweise zwischen 15 und 60 Massen-%, weiterhin vorzugsweise zwischen 20 und 40 Massen-% liegt und/oder daß das Verhältnis von monoklinem zu tetragonalem ZrO₂ (3 bis 4) : (7 bis 6) beträgt und daß ZrCN in kubischer Form vorliegen.

6. Verbundkörper nach einem der Ansprüche 1 bis 5, dadurch gekennzeichnet, daß der Substratkörper aus Hartmetall, einem Cermet oder einer Keramik besteht, wobei vorzugsweise der Substratkörper mehrlagig beschichtet ist und mindestens eine Schicht aus Carbiden, Nitriden und/oder Carbonitriden der Elemente der IVa- bis VIa-Gruppe des Periodensystemes und/oder aus Al₂O₃ und/oder ZrO₂ oder eine diamantähnliche Schicht, wobei die genannten Oxid-Schichten oder die diamantähnliche Schicht vorzugsweise die äußere Schicht bilden und/oder die Schicht aus ZrO₂ und ZrCN die äußerste Schicht ist, vorzugsweise mit einer unter dieser Schicht angeordneten Al₂O₃-Schicht.

7. Verbundkörper nach einem Anspruch 6, gekennzeichnet durch eine von innen nach außen auf den Substratkörper aufgebrachte Schichtfolge mit folgenden Dicken: TiN: 0,5 bis 2 µm, vorzugsweise bis 1 µm; TiCN: 2 bis 5 µm; ZrCN/ZrO₂: 2 bis 10 µm.

8. Verfahren zur Herstellung einer zwei oder drei Phasen enthaltenden Schicht auf einem beschichteten oder unbeschichteten Substratkörper aus einem Hartmetall, einem Cermet oder einer Keramik, mittels einer CVD-Abscheidung bei Temperaturen zwischen 800°C bis 950°C, bei dem in der Gasphase Zr-Halogenide in stöchiometrischem Überschuß, CO₂, H₂ und ein Stoff mit einer C-N-Gruppe als Kohlenstoff- und Stickstoff-Donator bei einem Druck zwischen 5 kPa und 100 kPa enthalten sind.

9. Verfahren nach Anspruch 8, daß die C-N-Molekülgruppe eine Cyanidgruppe-CN mit einer Dreifachbindung zwischen dem Kohlenstoff und dem Stickstoff enthält, deren Abstand bei Raumtemperatur zwischen 0,114 und 0,118 nm beträgt, vorzugsweise unter Verwendung von Acetonitril und/oder daß die CN-Molekülgruppe Molekülgruppen mit einer einfachen Bindung zwischen dem Kohlenstoff und dem Stickstoff enthält.

10. Verfahren nach Anspruch 8 oder 9, dadurch gekennzeichnet, daß die Beschichtungstemperatur zwischen 900°C und 920°C liegt und/oder daß durch gezielte Variation des CO₂-Anteiles in der Gasphase über die Beschichtungszeit ein ZrO₂-Anteilsgradient eingestellt wird, wobei vorzugsweise durch Einstellung der Beschichtungstemperatur das Verhältnis von monoklinem zu tetragonalem ZrO₂ variiert wird.

## Claims

1. Composite body consisting of a substrate body with a single-layer or multi-layer coating,
**characterized in that**
at least one layer has two or three phases made of a cubic ZrCN and monoclinic and/or tetragonal ZrO₂.

2. Composite body according to claim 1, characterized in that the ZrCN/ZrO₂-layer has a thickness of at least 2 µm, preferably 3 µm to 10 µm.

3. Composite body according to claim 1 or 2, characterized in that the ZrCN/ZrO₂-layer has different mass ratios of ZrCN/ZrO₂ dependent upon the distance from the boundary surface, whereby preferably the ZrO₂-content of the ZrCN/ZrO₂-layer which is a single-layer or the outermost layer, decreases outwardly, preferably to 0°.

4. Composite body according to claim 3, characterized in that the ZrCN/ZrO₂-layer is a first of a plurality of layers or has an intermediate layer and has a ZrO₂-proportion increasing inwardly to 100 %, preferably to a boundary ratio with the substrate body.

5. Composite body according to one of claims 1 to 4, characterized in that the relative mass proportions of the ZrO₂-phase lie between 5 and 75 mass-%, preferably between 15 and 60 mass-% and furthermore preferably between 20 and 40 mass-% and/or that the ratio of monoclinic to tetragonal ZrO₂ amounts to (3 to 4) : (7 to 6) and the ZrCN is present in cubic form.

6. Composite body according to one of claims 1 to 5, characterized in that the substrate body is comprised of hard metal, a cermet or a ceramic, whereby preferably the substrate body is coated with a multi-layer and at least one layer is comprised of carbides, nitrides and/or carbonitrides of the elements from groups IVa to VIa of the periodic system and/or from Al₂O₃ and/or ZrO₂ or a diamond-like layer, whereby the oxide-layer or the diamond-like layer is preferably the outermost layer and/or that the layer of ZrO₂ and ZrCN is the outermost layer, preferably with a layer of Al₂O₃ underlying this layer.

7. Composite body according to claim 6, characterized by a layer sequence from the inner side to the exterior of the substrate body with the following thicknesses: TiN: 0,5 to 2 µm, preferably up to 1 µm; TiCN: 2 to 5 µm; ZrCN/ZrO₂: 2 to 10 µm.

8. Method for producing a two or three phase containing layer on a coated or uncoated substrate body composed of a hard metal, a cermet or a ceramic, by means of a CVD-deposition at a temperature between 800°C to 950°C with a Zr-halogenide in stoichiometric excess in the gas phase, CO₂, H₂ and a material with a C-N-group as a carbon and nitrogen donor at a pressure between 5 kPa and 100 kPa.

9. Method according to claim 8 wherein the C-N molecular group is a cyanide group-CN with a triple bond between the carbon and the nitrogen, whose bond spacing at room temperature is between 0,114 and 0,118 nm, preferably using acetonitrile and/or that the C-N molecular groups contain molecular groupings with a simple bond between the carbon and the nitrogen.

10. Method according to claim 8 or 9, characterized in that the coating temperature is between 900°C and 920°C and/or that by a targeted variation in the CO₂-proportion in the gas phase during the coating time for establishment of a ZrO₂-concentration gradient, whereby preferably by a variation in the ratio of monoclinic to tetragonal ZrO₂ by adjustment of the coating temperature.

## Revendications

1. Corps composite se composant d'un corps substrat avec un revêtement à une ou à plusieurs couches,
**caractérisé par le fait**
que du moins une couche présente deux ou trois phases, se composant de ZrCN cubique et de ZrO₂ monoclinique et/ou tétragone.

2. Corps composite selon la revendication 1, caractérisé par le fait que la couche en ZrCN/ZrO₂ présente une épaisseur d'au moins 2 µm, de préférence de 3 µ m, à 10 µm.

3. Corps composite selon la revendication 1 ou 2, caractérisé par le fait que la couche en ZrCN/ZrO₂ présente un rapport différent de masse ZrCN/ZrO₂ dépendant de la distance à la surface limite, de préférence, la teneur en ZrO₂ de la couche en ZrCN/ZrO₂ qui est la seule couche ou la couche la plus extérieure, diminuant vers l'extérieur, de préférence elle passe à 0.

4. Corps composite selon la revendication 3, caractérisé par le fait que la couche en ZrCN/ZrO₂ est une première de plusieurs couches ou une couche intermédiaire et qu'elle présente une part de ZrO₂ qui, vers l'intérieur, passe à 100 %, de préférence en tant que zone limite vers le corps substrat.

5. Corps composite selon l'une des revendications 1 à 4, caractérisé par le fait que la part relative de masse de la phase de ZrO₂ est comprise entre 5 et 75 % en masse, de préférence entre 15 et 60 % en masse, en outre de préférence entre 20 et 40 % en masse, et/ou que le rapport de ZrO₂ monoclinique à ZrO₂ tétragone est de (3 à 4) : (7 à 6), et que le ZrCN est présent en forme cubique.

6. Corps composite selon l'une des revendications 1 à 5, caractérisé par le fait que le corps substrat se compose de métal dur, d'un cermet ou d'une céramique, de préférence, le corps substrat étant revêtu de plusieurs couches et une couche du moins se composant de carbures, de nitrures et/ou de carbonitrures des éléments du groupe IVa à Vla de la classification périodique des éléments et/ou de Al₂O₃ et/ou de ZrO₂ ou étant une couche diamantaire, les couches d'oxyde mentionnées ou ladite couche diamantaire formant de préférence la couche extérieure et/ou la couche en ZrO₂ et en ZrCN étant la couche la plus extérieure, de préférence avec une couche de Al₂O₃ disposée au-dessous de cette couche.

7. Corps composite selon la revendication 6, caractérisé par une suite de couches appliquées de l'intérieur vers l'extérieur sur le corps substrat, avec les épaisseurs suivantes: TiN: 0,5 à 2 µm, de préférence à 1 µm; TiCN: 2 à 5 µm; ZrCN/ZrO₂: 2 à 10 µm.

8. Procédé de fabrication d'une couche contenant deux ou trois phases, sur un corps substrat revêtu ou non revêtu en un métal dur, un cermet ou une céramique, au moyen d'une déposition CVD à des températures comprises entre 800°C et 950°C, dans lequel la phase gazeuse contient des halogénures de Zr en excès stoechiométrique, CO₂, H₂ et une substance avec un groupe C-N en tant que donneur de carbone et d'azote, à une pression comprise entre 5 kPa et 100 kPa.

9. Procédé selon la revendication 8, caractérisé par le fait que le groupe moléculaire C-N comprend un groupe cyanure CN avec une liaison triple entre le carbone et l'azote, dont la distance à la température ambiante est comprise entre 0,114 et 0,118 nm, de préférence avec l'utilisation d'acétonitrile, et/ou que le groupe moléculaire CN contient des groupes moléculaires avec une liaison simple entre le carbone et l'azote.

10. Procédé selon la revendication 8 ou 9, caractérisé par le fait que la température de revêtement est comprise entre 900°C et 920°C et/ou que, par une variation voulue de la part de CO₂ dans la phase gazeuse, un gradient de concentration de ZrO₂ est réglé durant le temps de revêtement, de préférence, le rapport de ZrO₂ monoclinique à ZrO₂ tétragone étant varié par un réglage de la température de revêtement.
